# EUROPÄISCHE PATENTSCHRIFT

(11) **EP 1 105 740 B1**
(45) Veröffentlichungstag und Bekanntmachung des Hinweises auf die Patenterteilung: **04.10.2006**
(21) Anmeldenummer: 99952389.7
(22) Anmeldetag: 13.08.1999
(51) Int. Cl.: G01P 1/02, G01D 11/24, G01P 3/481, F16H 61/00, G01B 7/00

(54) **ELEKTRONISCHE SENSORANORDNUNG**
ELECTRONIC SENSOR ARRANGEMENT
SYSTEME DE DETECTION ELECTRONIQUE

(30) Priorität: 19.08.1998 DE 19837640
(43) Veröffentlichungstag der Anmeldung: 13.06.2001
(73) Patentinhaber: SIEMENS AKTIENGESELLSCHAFT, 80333 München (DE)
(72) Erfinder: LOIBL, Josef, D-94209 Regen (DE); SCHEUERER, Ulf, D-93047 Regensburg (DE)
(86) Internationale Anmeldenummer: PCT/DE1999/002537
(87) Internationale Veröffentlichungsnummer: WO 2000/011481

(56) Entgegenhaltungen:
- EP-A- 0 217 365
- DE-A- 19 604 489
- DE-A1- 3 827 937
- DE-C- 4 415 133
- DE-U- 29 513 950
- DE-U- 29 714 223

## Beschreibung

Die Erfindung betrifft eine elektronische Sensoranordnung zur Unterbringung in einem Automatikgetriebe in Kraftfahrzeugen.

Zum Hintergrund der Erfindung ist festzuhalten, daß Automatikgetriebe für Personenkraftfahrzeuge üblicherweise elektronisch gesteuert werden. Die Steuergeräte hierfür waren bisher als sogenannte "Stand-alone"-Einheiten in einem vor Umwelteinflüssen geschützten Steuerkasten vorgesehen oder wurden direkt im Passagierraum des Fahrzeugs verbaut. In jüngster Zeit wurde dazu übergegangen, die Steuerelektronik und die zugehörige Sensorik direkt in das Automatikgetriebe zu integrieren. Bezüglich der Sensorik ist festzuhalten, daß es sich dabei im Zusammenhang mit Automatikgetrieben in erster Linie um einen Positionserkennungssensor handelt, mit dem erfaßt wird, welcher Fahrbereich des Automatikgetriebes eingestellt ist. Letzteres erfolgt beispielsweise durch eine Einstellung des sogenannten Wählbereichsschalters in eine der Positionen "P" (= Parken), "R" =(= Retour), "N" = (= Neutral) oder "D" (= Drive). Der Wählbereichsschalter ist an das Automatikgetriebe mechanisch angebunden, indem er einen linear oder rotatorisch beweglichen Wählschieber betätigt. Dieser ist in den hydraulischen Teil der Getriebesteuerung eingebunden. Durch die Erfassung der Wählschieberposition mittels des Positionserkennungssensors wird dem elektronischen Steuergerät die eingestellte Fahrstufe mitgeteilt.

Bezüglich der Positionserkennung ist es nun bekannt, einen eigenständigen Sensor vorzusehen, der zum Schutz vor dem Umgebungsmedium, nämlich Getriebeöl, öldicht in einem Gehäuse verpackt ist. Auch die elektrische Verbindung des Sensors über entsprechende Leitungen zum Steuergerät muß öldicht ausgelegt sein.

Für die eigentliche Ausgestaltung der Sensoren sind verschiedene Meßprinzipien denkbar. So können beispielsweise Magnetfeldsensoren vorgesehen sein, die auf dem Hall-Effekt basieren. Dies ist beispielsweise aus der DE 196 03 197 C1 bekannt. Auch Magnetfeldsensoren basierend auf dem GMR-Effekt (= Giant Magneto Resistive Effect) sind denkbar. Schließlich sind induktiv oder kapazitiv arbeitende Sensoren zur Positionserfassung eines Metallteils am Wählschieber ebenfalls einsetzbar.

Neben den Positionserkennungssensoren sind noch Drehzahlsensoren, Drucksensoren und Temperatursensoren von Bedeutung.

Aus der Druckschrift DE 41 42 727 A1 ist ein Drehzahlsensor bekannt, bei dem der Innenraum eines topfförmigen Deckels mit einem Zusatzdeckel dicht verschlossen wird. Auf diese Weise wird eine im Innenraum angeordnete Leiterplatte mit ihrer elektronischen Beschaltung sowie elektronischen Bauelementen, wie z.B. einem Hall-Element, gegen Staub, Flüssigkeiten ,Dämpfe und dergleichen geschützt. Die elektrische Verbindung des Sensors nach außen hin erfolgt über elektrische Leiter. Um die Funktionsfähigkeit des Sensors zu gewährleisten muß diese elektrische Verbindung ebenfalls dicht ausgeführt sein.

Aus der Druckschrift DE 38 27 937 A1 ist es bekannt, die Meßschaltung eines elektrischen Meßwertaufnehmers über ein flexibles Leitungsstück, zum Beispiel eine flexible Leiterplatte, mit einem Anschlußkabel zu verbinden. Auch bei dieser Anordnung ist einerseits eine Abdichtung des Gehäuses des Meßwertaufnehmers und andererseits eine dichte Auslegung der elektrischen Verbindung über Adern des Anschlußkabels erforderlich.

Nachteilig bei den bisher verwendeten Sensoranordnungen ist die Tatsache, daß die öldichte Unterbringung und Ankopplung der Sensoren an die Steuerelektronik, insbesondere im Hinblick auf eine möglichst hohe Fertigungsrationalisierung, wie sie im Automobilbau angestrebt wird, zu aufwendig ist.

In der EP 0 217 365 wird ein Druckaufnehmer zum Messen des Luftdruckes eines luftgefüllten Fahrzeugreifens beschrieben. In einem mit Gas gefüllten, gasdichten Gehäuse in Flachbauweise sind auf einer Trägerfolie zwei Kontaktfelder angeordnet. Auf einem Kontaktfeld stützt sich eine Kontaktbrücke ab. Bei Überschreiten eines Grenzdruckes wird unter Verformung der Kontaktbrücke auch das zweite Kontaktfeld kontaktiert. Zur Lagefixierung der Kontaktbrücke und zur Bildung von Ausweichkammern für aus dem Raum der Kontaktfeder und Kontaktbrücke bei Überschreiten des Grenzdruckes verdrängtes Gas sind zwischen den beiden äußeren Folien strahlenförmig verlaufende Rippen vorgesehen.

Aus der DE 196 04 489 A1 geht eine elektrische Positionsmesseinrichtung hervor. Bei einem Drehgeber befinden sich elektrische Bauelemente auf einer flexiblen gedruckten Schaltung mit der Leiterbahnen aus einem Gehäuse des Drehgebers herausgeführt werden. Die flexible gedruckte Schaltung ist elektrisch abgeschirmt und die Abschirmung mit dem Gehäuse verbunden. Die Verbindung wird durch Klemmung hergestellt, so dass mit der elektrischen Verbindung auch eine mechanische Zugentlastung gebildet wird.

Davon ausgehend liegt der Erfindung die Aufgabe zugrunde, eine besonders einfache und kostengünstige Einbindung von Sensoren in ein Automatikgetriebe zu schaffen.

Diese Aufgabe wird durch die Merkmale des Anspruchs 1 gelöst. Vorteilhaft ist, daß hierdurch ein "Stand-alone"-Gehäuse entfällt. Der Leiterbahnträger ist als flexible Leiterbahn-Folie ausgebildet, die flüssigkeitsdicht mit dem Gehäusedeckel verbunden ist. Aufgrund dessen kommt es auf eine flüssigkeitsdichte Verbindung der Leiterbahn-Folie mit der Bodenplatte nicht an. Eine separate Abdichtung des Gehäuse-Innenraums, zum Beispiel durch Vergußmasse, ist nicht erforderlich.

Gemäß Anspruch 3 kann die Bodenplatte aus Kunststoff oder einem paramagnetischen permeablem Metall, wie z. B. Aluminium, bestehen.

Gemäß Anspruch 5 haben sich Hall-Sensoren als Positionserkennungssensoren als vorteilhaft herausgestellt. Die elektrische Verbindung zur Steuerelektronik erfolgt dann vorzugsweise durch Bonden.

Gemäß Anspruch 7 ist das Sensor-Element vorteilhafterweise als Drehzahlsensor ausgebildet.

Zusätzliche vorteilhafte Ausgestaltungen ergeben sich aus den Unteransprüchen.

Weitere Merkmale, Einzelheiten und Vorteile der Erfindung sind der nachfolgenden Beschreibung entnehmbar, in der zwei Ausführungsbeispiele des Erfindungsgegenstandes anhand der beigefügten Zeichnungen näher erläutert sind. Es zeigen:
- Fig. 1: eine Seitenquerschnittsansicht einer Sensoranordnung gemäß einer ersten Ausführungsform,
- Fig. 2: eine Draufsicht auf die Sensoranordnung gemäß Figur 1 und
- Fig. 3: eine schematische Seitenquerschnittsansicht einer Sensoranordnung gemäß einer zweiten Ausführungsform.

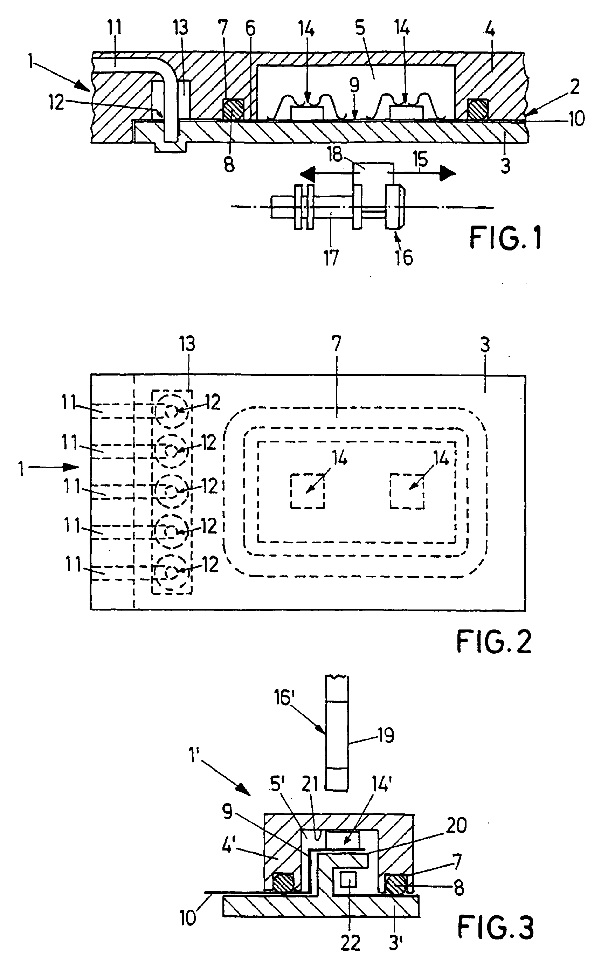

Eine erste Ausführungsform einer elektronischen Sensoranordnung 1 ist in den Figuren 1 und 2 gezeigt.

Die Sensoranordnung 1 für ein Automatikgetriebe eines Kraftfahrzeugs weist ein Gehäuse 2 auf, welches durch eine Bodenplatte 3 und einen Gehäusedeckel 4 gebildet wird. Der Gehäusedeckel 4 weist einen Gehäusedeckel-Innenraum 5 auf, der an der Unterseite 6 des Gehäusedeckels 4 von einer Dichtnut 7 umgeben ist. In der Dichtnut 7 ist ein Dichtungselement 8, insbesondere ein Dichtring, vorgesehen, der den Innenraum 5 gegenüber der Umgebung des Gehäuses 2 flüssigkeitsdicht, insbesondere öldicht, abdichtet. Der Gehäusedeckel 4 ist an der Bodenplatte 3 angenietet oder in einer anderen geeigneten Weise mit dieser verbunden. Der Gehäusedeckel 4 kann einteilig mit einem Gesamtdeckel für die Elektronik des Getriebes ausgebildet sein. Diese Ausführung ist besonders vorteilhaft.

Auf der Bodenplatte 3 ist ein Leiterbahnträger 9 mit dieser flächig verbunden vorgesehen. Bei dem Leiterbahnträger 9 handelt es sich um eine flexible Leiterbahn-Folie 10 bekannten Typs, die auf der Bodenplatte 3 aufgeklebt ist und sich über den Bereich des Innenraums 5 hinaus erstreckt. Zur elektrischen Kontaktierung der Leiterbahn-Folie 10 sind Anschlußdrähte 11 vorgesehen, die von außen durch den Gehäusedeckel 4 geführt sind und in der Bodenplatte 3 elektrisch leitend mit der Leiterbahn-Folie 10 verbunden befestigt sind. Oberhalb des Kontaktbereichs 12 zwischen den Anschlußdrähten 11 und der Bodenplatte 3 ist eine Ausnehmung 13 zum Ausgleich von Fertigungstoleranzen vorgesehen. Eine weitere Möglichkeit der Kontaktierung der flexiblen Leiterbahn-Folie 10 zu Drähten, Stanzgittern oder einer zweiten flexiblen Leiterbahn-Folie 10 ist z. B. durch Schweißen oder Löten möglich.

Im Innenraum 5 sind auf der Leiterbahn-Folie 10 mit dieser elektrisch verbundene Sensor-Elemente 14 vorgesehen, die der Positionserkennung dienen. Die Sensor-Elemente 14 sind als Hall-Sensoren ausgebildet. Es können jedoch auch Spulenelemente zur Positionserkennung vorgesehen sein. Unterhalb der Bodenplatte 3 ist ein entlang einer Verschiebe-Richtung 15 verschiebbares Geber-Element 16 vorgesehen. Das Geber-Element 16 ist als Wählschieber 17 der Hydraulik des Automatikgetriebes ausgebildet. Dieser trägt einen Magneten 18 auf der der Bodenplatte 3 zugewandten Seite. Das Geber-Element 16 kann auch in anderer bekannter Weise ausgebildet sein.

Beim Betrieb wird der von Öl umgebene Wählschieber 17 in eine vom Benutzer des Automatikgetriebes gewünschte Position gebracht. Aufgrund der Wechselwirkung zwischen dem Magneten 18 und den Sensor-Elementen 14 kann die Position des Wählschiebers 17 bestimmt werden. Die ermittelten Positionssignale werden über die Anschlußdrähte 11 an das Getriebe weitergeleitet.

Eine zweite Ausführungsform der Erfindung ist in Figur 3 dargestellt. Im folgenden werden lediglich die Unterschiede beschrieben. Identische Teile sind mit demselben Bezugszeichen versehen. Verschiedene, jedoch funktionell gleichwertige Elemente werden mit dem entsprechenden apostrophierten Bezugszeichen versehen.

Die Sensoranordnung 1' dient der Drehzahlmessung in einem Automatikgetriebe. Das Geber-Element 16' ist als rotierendes Geber-Rad 19, insbesondere als Zahnrad oder magnetisches Impulsrad, ausgebildet, welches in Figur 3 oberhalb des Gehäuse-Deckels 4' angeordnet ist. Innerhalb des Innenraums 5' ist ein Träger 20 vorgesehen, der mit der Bodenplatte 3' verbunden ist und auf dem der Leiterbahnträger 9 angebracht ist. Auf dem Träger 20 in der Nähe der Decke 21 des Innenraums 5' ist das Sensor-Element 14' angeordnet, so daß dieses dem Geber-Element 16' ausreichend nah ist. In Abhängigkeit von der Funktionsweise des Sensor-Elements 14' kann unter diesem ein Magnet 22 vorgesehen sein.

## Patentansprüche

1. Elektronische Sensoranordnung (1; 1') zur Unterbringung in einem Automatikgetriebe, umfassend
A. ein Gehäuse (2; 2') aus einer Bodenplatte (3; 3') und einem damit verbundenen Gehäusedeckel (4; 4'), wobei das Gehäuse (2; 2') einen flüssigkeitsdichten, insbesondere öldichten, Innenraum (5) aufweist,
B. einen auf der dem Gehäusedeckel (4; 4') zugewandten Seite der Bodenplatte (3; 3') angebrachten Leiterbahnträger (9), der als flexible Leiterbahn-Folie (10) ausgebildet ist und sich über den Bereich des Innenraums (5) hinaus erstreckt, wobei die Leiterbahnfolie (10) flüssigkeitsdicht mit dem Gebäudedeckel (4; 4') verbunden ist,
C. ein im Innenraum angeordnetes und mit dem Leiterbahnträger (9) elektrisch verbundenes, Sensor-Element (14; 14') und
D. ein außerhalb des Gehäuses (2; 2') angeordnetes Geber-Element (16; 16') zum Zusammenwirken mit dem Sensor-Element (14; 14').

2. Elektronische Sensoranordnung (1; 1') gemäß Anspruch 1, wobei die flexible Leiterbahn-Folie (10) auf die Bodenplatte (3; 3') aufgeklebt ist.

3. Elektronische Sensoranordnung (1; 1') gemäß einem der vorangehenden Ansprüche, wobei die Bodenplatte (3; 3') aus Kunststoff oder einem paramagnetischen Metall, insbesondere Aluminium, besteht.

4. Elektronische Sensoranordnung (1) gemäß einem der vorangehenden Ansprüche, wobei das Sensor-Element (14) ein Positionserkennungssensor ist.

5. Elektronische Sensoranordnung (1) gemäß Anspruch 4, wobei das Sensor-Element (14) als Hall-Sensor und/oder das Geber-Element (16) als Magnet ausgebildet ist.

6. Elektronische Sensoranordnung (1) gemäß Ansprüchen 4 oder 5, wobei das Geber-Element (16) an der Außenseite der Bodenplatte (3) angeordnet ist.

7. Elektronische Sensoranordnung (1') gemäß einem der Ansprüche 1 bis 3, wobei das Sensor-Element (14') als Drehzahlsensor ausgebildet ist.

8. Elektronische Sensoranordnung (1') gemäß Anspruch 7, wobei das Geber-Element (16') umfangsseitig an einem drehbaren Geber-Rad (19) angeordnet ist.

9. Elektronische Sensoranordnung (1') gemäß einem der Ansprüche 7 oder 8, wobei das Geber-Element (16') auf derselben Seite der Bodenplatte (3') wie das Sensor-Element (14') angeordnet ist.

10. Elektronische Sensoranordnung (1') gemäß einem der Ansprüche 7 bis 9, wobei im Innenraum (5') des Gehäuses (2') ein mit der Bodenplatte (3') verbundenes Tragelement (20) zur Aufnahme des Sensor-Elements (14')vorgesehen ist.

11. Elektronische Sensoranordnung (1') gemäß Anspruch 10, wobei zwischen dem Sensor-Element (14') und der Bodenplatte (3') ein Magnet (22) zum Zusammenwirken mit dem Sensor-Element (14') vorgesehen ist.

## Claims

1. Electronic sensor array (1: 1') for installation in an automatic gearbox, comprising
A. A housing (2; 2') composed of a baseplate (3; 3') and a housing lid (4; 4') which is connected thereto, the housing (2; 2') having a fluid-tight, in particular oil-tight, interior (5),
B. A conductor track carrier (9) which is mounted on the side of the baseplate (3; 3') facing the housing lid (4; 4') and is embodied as a flexible conductor track foil (10) and extends over the region of the interior (5), wherein the conductor track foil (10) is connected to the housing lid (4; 4') in a fluid tight fashion,
C. A sensor element (14; 14') which is arranged in the interior and is electrically connected to the conductor track carrier (9), and
D. A detector element (16; 16') which is arranged outside the housing (2; 2') and has the purpose of interacting with the sensor element (14; 14').

2. Electronic sensor array (1; 1') according to Claim 1, the flexible conductor track foil (10) being bonded onto the baseplate (3; 3').

3. Electronic sensor array (1; 1') according to one of the preceding claims, the baseplate (3; 3') being composed of plastic or a paramagnetic metal, in particular aluminium.

4. Electronic sensor array (1) according to one of the preceding claims, the sensor element (14) being a position detection sensor.

5. Electronic sensor array (1) according to Claim 4, the sensor element (14) being embodied as a hall sensor, and/or the detector element (16) being embodied as a magnet.

6. Electronic sensor array (1) according to Claims 4 or 5, the detector element (16) being arranged on the outside of the baseplate (3).

7. Electronic sensor array (1') according to one of Claims 1 to 3, the sensor element (14') being embodied as an rpm sensor.

8. Electronic sensor array (1') according to Claim 7, the detector element (16) being arranged on the circumference of a rotatable detector wheel (19).

9. Electronic sensor array (1') according to one of Claims 7 or 8, the detector element (16') being arranged on the same side of the baseplate (3') as the sensor element (14').

10. Electronic sensor array (1') according to one of Claims 7 to 9, a mounting element (20) which is connected to the baseplate (3') and which has the purpose of holding the sensor element (14') being provided in the interior (5') of the housing (2').

11. Electronic sensor array (1') according to Claim 10, a magnet (22) for interacting with the sensor element (14') being provided between the sensor element (14') and the baseplate (3').

## Revendications

1. Dispositif de détection électronique (1; 1') destiné à être logé dans une boîte de vitesses automatique, comprenant:
A. un boîtier (2; 2') composé d'une plaque de fond (3; 3') et d'un couvercle de boîtier (4; 4') relié à celle-ci, le boîtier (2; 2') présentant un espace intérieur (5) étanche aux liquides, en particulier étanche à l'huile;
B. un support de pistes conductrices (9) placé sur le côté de la plaque de fond (3; 3') tourné vers le couvercle de boîtier (4; 4'), lequel support est réalisé en tant que feuille souple de pistes conductrices (10) et s'étend au-delà de la zone de l'espace intérieur (5), la feuille de pistes conductrices (10) étant reliée au couvercle de boîtier (4; 4') de manière étanche aux liquides;
C. un élément de détection (14; 14') situé dans l'espace intérieur et relié électriquement au support de pistes conductrices (9) et
D. un élément capteur (16; 16') situé à l'extérieur du boîtier (2; 2') pour coopérer avec l'élément de détection (14; 14').

2. Dispositif de détection électronique (1; 1') selon la revendication 1, la feuille souple de pistes conductrices (10) étant collée sur la plaque de fond (3; 3').

3. Dispositif de détection électronique (1; 1') selon l'une des revendications précédentes, la plaque de fond (3; 3') se composant de matière plastique ou d'un métal paramagnétique, en particulier d'aluminium.

4. Dispositif de détection électronique (1) selon l'une des revendications précédentes, l'élément de détection (14) étant un détecteur d'identification de position.

5. Dispositif de détection électronique (1) selon la revendication 4, l'élément de détection (14) étant réalisé en tant que détecteur Hall et/ou l'élément capteur (16), en tant qu'aimant.

6. Dispositif de détection électronique (1) selon les revendications 4 ou 5, l'élément capteur (16) étant situé sur le côté extérieur de la plaque de fond (3).

7. Dispositif de détection électronique (1') selon l'une des revendications 1 à 3, l'élément de détection (14') étant réalisé en tant que détecteur tachymétrique.

8. Dispositif de détection électronique (1') selon la revendication 7, l'élément capteur (16') étant situé sur une roue capteur tournante (19), sur le côté pourtour.

9. Dispositif de détection électronique (1') selon l'une des revendications 7 ou 8, l'élément capteur (16') étant situé sur le même côté de la plaque de fond (3') que l'élément de détection (14').

10. Dispositif de détection électronique (1') selon l'une des revendications 7 à 9, un élément de support (20) relié à la plaque de fond (3') étant prévu dans l'espace intérieur (5') du boîtier (2') pour recevoir l'élément de détection (14').

11. Dispositif de détection électronique (1') selon la revendication 10, un aimant (22) étant prévu entre l'élément de détection (14') et la plaque de fond (3') pour coopérer avec l'élément de détection (14').
